# EUROPÄISCHE PATENTSCHRIFT

(11) **EP 0 426 798 B1**
(45) Veröffentlichungstag und Bekanntmachung des Hinweises auf die Patenterteilung: **08.09.1993**
(21) Anmeldenummer: 90906845.4
(22) Anmeldetag: 29.05.1990
(51) Int. Cl.: H05K 13/04, H01R 43/20

(54) **VORRICHTUNG ZUM HANDHABEN VON OBJEKTEN UND ANWENDUNG DER VORRICHTUNG**
DEVICE FOR HANDLING OBJECTS AND USE OF SAID OBJECTS
DISPOSITIF DE MANIPULATION D'OBJETS ET SON APPLICATION

(30) Priorität: 01.06.1989 CH 2068/89
(43) Veröffentlichungstag der Anmeldung: 15.05.1991
(73) Patentinhaber: SIEMENS-ALBIS AKTIENGESELLSCHAFT, 8047 Zürich (CH); SIEMENS AKTIENGESELLSCHAFT, 80333 München (DE)
(72) Erfinder: FISCHER, Bruno, CH-8953 Dietikon (CH); BACHOFEN, Bruno, CH-8906 Bonstetten (CH)
(86) Internationale Anmeldenummer: CH9000137
(87) Internationale Veröffentlichungsnummer: WO9015518

(56) Entgegenhaltungen:
- EP-A- 71 303
- GB-A- 2 036 611

## Beschreibung

Die vorliegende Erfindung betrifft eine Vorrichtung zum Handhaben von Objekten und verschiedene Anwendungen der Vorrichtung.

In verschiedensten Anwendungsgebieten der automatischen Seriefertigung besteht oft das Problem, innerhalb eines Bearbeitungszyklus Gegenstände einer Zuführung zu entnehmen und in bestimmter Anzahl einer anschliessenden Bearbeitungsstation zuzuleiten. Ein typischer Anwendungsfall ist das Bestücken von Komponenten elektrotechnischer Erzeugnisse mit Anschlusselementen, die der Herstellung von elektrischen Verbindungen mit anderen Komponenten dienen. So müssen beispielsweise Leiterplatten oder Steckverbinder mit einer Vielzahl von metallischen Kontaktelementen bestückt werden, die in dafür vorgesehene Öffnungen eingelötet oder eingepresst werden. Die Kontakte werden dabei in der Regel auf Bändern angeliefert, von diesen entnommen und der weiteren Verarbeitung zugeführt. Aus der DE-OS 29 50 460 ist eine Vorrichtung zum Einsetzen von Anschlussstiften in ein Werkstück bekannt, bei der die Anschlussstifte mittels einer Spannvorrichtung einem Trägerstreifen entnommen und einzeln einer Einsetzvorrichtung zugeführt werden. Es kann also nur ein Stift nach dem andern in das Werkstück eingesetzt werden, was gerade bei einer Grossseriefertigung von Steckverbindern und dergleichen wirtschaftlich nicht mehr vertretbare Durchlaufzeiten zur Folge haben kann. Es ist auch bekannt, einzelne Kontaktreihen von Steckverbindern jeweils in einem Arbeitsgang vollständig zu bestücken, d.h. sämtliche Kon-taktpositionen einer Reihe gleichzeitig mit einem Kontaktelement zu versehen. In vielen Anwendungsfällen werden aber nicht alle Kontaktelemente benötigt, weshalb das Bedürfnis entsteht, bei der Fertigung nur die tatsächlich benützten Positionen mit einem Kontaktelement zu bestücken, wobei verschiedenste " Muster " von Kontaktbelegungen auftreten können.

Der vorliegenden Erfindung liegt daher die Aufgabe zugrunde, eine für verschiedenste Einsatzfälle geeignete Vorrichtung der eingangs genannten Art zu schaffen, mit der nicht nur mehrere Gegenstände gleichzeitig gefasst, sondern ferner in frei wählbare Abstände zueinander gebracht und anschliessend so der Weiterverarbeitung zugeführt werden können. Die Lösung dieser Aufgabe gelingt erfindungsgemäss mit einer Vorrichtung gemäß Patentanspruch 1. Anwendungen der Vorrichtung gemäß Anspruch 1 sind in dem Ansprüchen 14 bis 16 definiert. Vorteilhafte Weiterbildungen sind in weiteren Ansprüchen angegeben.

Die Vorrichtung erlaubt, eine an sich beliebige Anzahl von Gegenstanden gleichzeitig in einen Bearbeitungsablauf einzubeziehen, wobei die Anzahl der Gegenstände und deren Abstande zueinander innerhalb eines vorgegebenen Rasters entsprechend den jeweiligen Gegebenheiten frei wahlbar sind. Damit wird es in einfacher Weise moglich, z.B. im oben erwähnten konkreten Anwendungsfall die Kontaktreihen bei Steckverbindern nach einem beliebigen Muster zu bestücken, d.h. wahlweise auch beliebige Kontaktpositionen unbestückt zu lassen. Der Einsatz der erfindungsgemassen Vorrichtung in einer Anlage zum automatischen Bestücken von elektrischen Komponenten -mit Kontaktelementen ermöglicht gerade bei beliebigen Mustern die dem Muster entsprechenden Pakete von Kontaktelementen gleichzeitig bereitzustellen, um sie so der eigentlichen Bestückungsstation zuzuführen, wo sie dann gemeinsam in einer einzigen Operation in die dafür vorgesehenen Öffnungen eines Trägers eingesetzt werden können. Dies gestattet im Vergleich zu bekannten Bestückungsverfahren eine erhebliche Verringerung der Bestückungszeit.

Aus der EP-A-0 071 303 ist eine andere Vorrichtung zum Positionieren von Bauelementen bekannt, wobei mehere Träger vorgesehen sind. Nach dem Aufnehmen der Bauelementes werden die Träger durch gegeneinander Verchrieben in ein Muster gebracht, das dem gewünschten Bestückungsmuster auf dem Substratentspricht.

Ausführungs- und Anwendungsbeispiele der Vorrichtung werden nachfolgend anhand von Zeichnungen näher erläutert. Es zeigt:
- Fig. 1: eine erste Ausführung der Vorrichtung
- Fig. 2: ein Schnittbild dieser Vorrichtung
- Fig. 3: eine Darstellung zur Funktionsweise der Vorrichtung
- Fig. 4 bis 6: verschiedene Positioniereinrichtungen
- Fig. 7 und 8: weitere Ausführungen der Vorrichtung
- Fig. 9: ein Anwendungsbeispiel der Vorrichtung

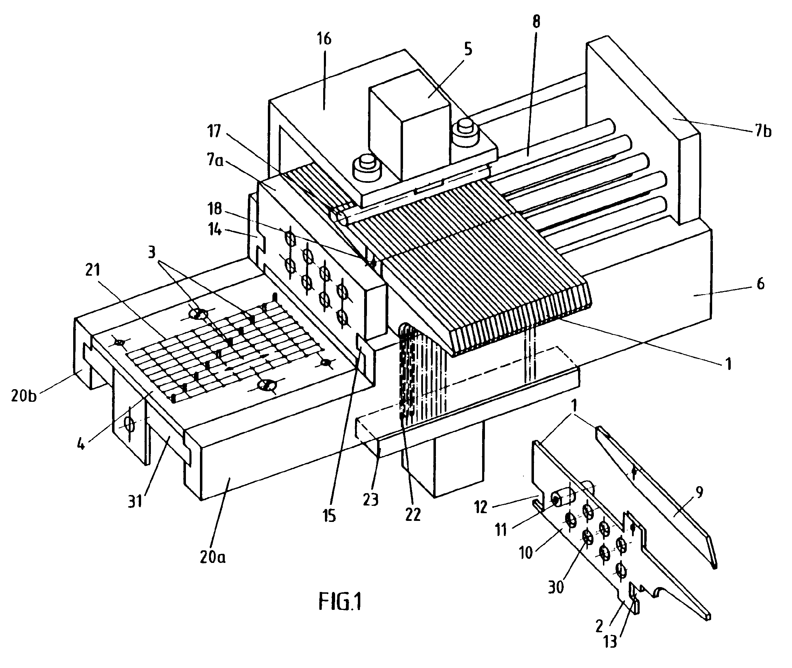

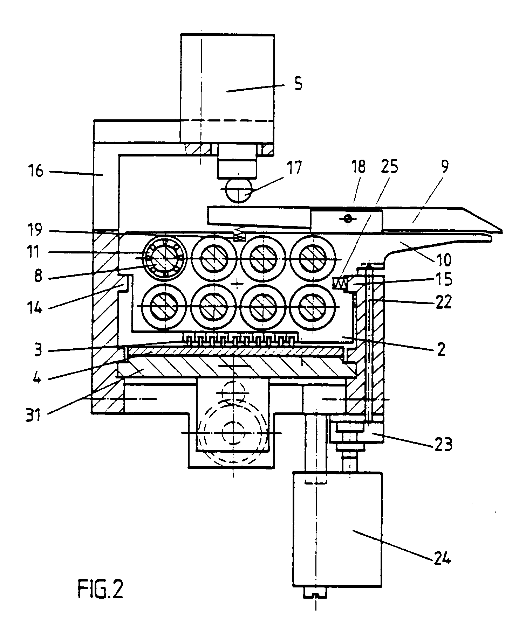

Die Vorrichtung gemäss Fig. 1 und 2 weist auf einem Träger 6 mehrere zwischen zwei Stützen 7a, 7b angeordnete und parallel zueinander verlaufende Führungssäulen 8 auf. Diese dienen je einem unter einer Vielzahl von zwischen den Stützen 7a, 7b verschiebbaren Objektträgern, z.B. Zangen 1, als Führung. Jede Zange 1 weist eine obere und eine untere Spannbacke 9, 10 auf. Die untere Spannbacke 10 ist mit einer ein Kugellager aufweisenden Führungshülse 11 versehen, durch die eine der Führungssäulen 8 hindurchführt. Im vorliegenden Beispiel sind die Zangen 1 sehr schmal ausgeführt, weshalb aus Stabilitätsgründen die Führungshülsen 11 beidseitig etwas hervorstehen. Um in diesem Fall trotzdem die einzelnen Zangen 1 möglichst nahe nebeneinander anordnen zu können, sind benachbarte Zangen 1 an unterschiedlichen Führungssäulen 8 geführt. Dabei ragt die Führungshülse 11 einer Zange 1 beidseitig jeweils frei durch entsprechende Bohrungen 30 der benachbarten Zangen 1. Die Dicke der Zangen 1 ist an sich frei wählbar. Die untere Spannbacke 10 weist an ihren beiden längsseitigen Enden zudem je einen Einschnitt 12, 13 auf, die in Führungen 14, 15 des Tragers 6 greifen und beim Verschieben der Zange 1 an diesem entlang gleiten. Eine Druckfeder 25 (Fig.2) zwischen der unteren Spannbacke 10 und der Führung 15 sorgt dafür, dass die Verschiebung der Zangen 1 gleichmässig abläuft. In Fig. 1 sind alle Zangen 1 ohne Zwischenraum nebeneinander in einer Ausgangslage, im folgenden Einsatzbereich genannt, angeordnet.

Alle im Einsatzbereich liegenden Zangen 1 befinden sich unter einer Zangen-Betätigungseinrichtung. Diese besteht im wesentlichen aus einem an einem Halter 16 befestigten pneumatischen Zylinder 5, der mit semem Kolben auf eine Druckstange 17 wirkt, die bei Betätigung des Zylinders 5 ihrerseits auf die obere Spannbacke 9 aller sich im Einsatzbereich befindlichen Zangen 1 wirkt. Die obere Spannbacke 9 sitzt in einer Halterung der unteren Spannbacke 10 und ist ist drehbar an einer Welle 18 gelagert. Zwischen dem im geschlossenen Zustand der Zange 1 nicht auf der unteren Spannbacke 10 aufliegenden hinteren Teil der oberen Spannbacke 9 und dem hinteren Teil der unteren Spannbacke 10 ist vertikal eine Druckfeder 19 eingefügt. Beim Öffnen der Zange 1 drückt die Druckstange 17 auf den hinteren Teil der oberen Spannbacke 9 gegen die Druckfeder 19. Sobald die Druckwirkung des Zylinders ausbleibt, nimmt die Zange 1 infolge der Wirkung der Druckfeder 19 selbsttätig wieder den geschlossenen Zustand ein. Die beiden vorderen Enden der Zange 1 sind entsprechend den zu fassenden Gegenständen ausgebildet.

Die untere Spannbacke 10 der Zange 1 ist an ihrer unteren Längsseite mit einer Positioniermarke 2 versehen, die durch einen für alle Zangen 1 unterschiedliche Länge aufweisenden Abschnitt gebildet wird. In Fig. 1 weist die vorderste Zange 1 (erste Zange auf der linken Seite) den kürzesten Abschnitt auf; bei allen nachfolgenden Zangen 1 ist dieser Abschnitt immer um einen bestimmten Betrag länger, d.h. bei der hintersten Zange 1 am längsten. Der Träger 6 der Vorrichtung gemäss Fig. 1 weist ferner zwei Absätze 20a, b mit je einer Führungsnut auf, in die sich ein Schlitten 31 mit einer auswechselbaren plattenförmigen Positioniereinrichtung 4 horizontal einschieben lässt. Der Schlitten 31 ist zusammen mit der Platte 4 unterhalb der Schienen 8 durch nicht weiter dargestellte z. B. pneumatische Mittel in Richtung der Zangen 1 verschiebbar. Auf der Oberseite der Platte 4 sind in einem maschenartigen Raster 21 angeordnete Vertiefungen vorgesehen, in die Positionierstifte 3 einsetzbar sind. Der Rasterabstand ist auf die Abmessungen der unterschiedlichen Positioniermarken 2 der Zangen 1 und auf den Abstand zwischen den Zangen 1 abgestimmt. Beim Einschieben des Schlittens 31 läuft jeder der auf der Platte 4 eingesetzten Positionierstifte 3 auf die entsprechende Positioniermarke 2 auf, worauf die betreffende Zange 1 und die allenfalls unmittelbar dahinterliegenden - in Fig. 1 die rechts davon liegenden - Zangen 1 nach hinten verschoben werden. Die Positionierstifte 3 können innerhalb des vorgegebenen Rasters beliebig gesetzt werden. So kann mit der Positioniereinrichtung 4 in einfacher Weise eine beliebige Anordnung der Zangen 1 zueinander erreicht werden.

Um die Zangen 1 in der gewünschten Anordnung zu fixieren, ist in dem die Führung 15 enthaltenden Teil des Tragers 6 an jeder moglichen Zangenposition innerhalb des Einsatzbereiches ein vertikaler Arretierstift 22 eingesetzt. Alle Stifte 22 sind an ihrem unteren Ende an einem Verbindungselement 23 befestigt, welches mit einer pneumatischen Hebeeinrichtung 24 verbunden und durch diese in vertikaler Richtung verschiebbar ist. Sobald die Zangen 1 die gewunschten Positionen eingenommen haben, wird die Hebeeinrichtung 24 aktiviert und dadurch werden alle sich im Einsatzbereich befindlichen Zangen 1 fixiert.

Selbstverständlich können an Stelle von Zangen 1 auch andere bekannte Objektträger der form - oder kraft - oder reibschlüssigen Art, wie z.B. magnetisch oder mittels Vakuum betriebene Greifelemente eingesetzt werden. Das Prinzip der erfindungsgemässen Vorrichtung wird dadurch nicht tangiert.

Das aus Fig. 1 ersichtliche Prinzip setzt nicht unbedingt voraus, dass zum Positionieren der Objektträger die Positionierplatte 4 in Richtung der Objektträger verschiebbar sein muss. Es ist ohne weiteres denkbar, die Platte 4 im Einsatzbereich festzuhalten und die durch elastische Mittel miteinander verbundenen Objektträger von ausserhalb des Einsatzbereiches in diesen hineinzubewegen, wo sie auf die Positionierstifte 3 auflaufen. Auch auf diese Weise lässt sich jede gewünschte Anordnung der Objektträger zueinander erzeugen. Dieses Vorgehen entspricht einer kinematischen Umkehr des oben anhand von Fig. 1 erläuterten Prinzips.

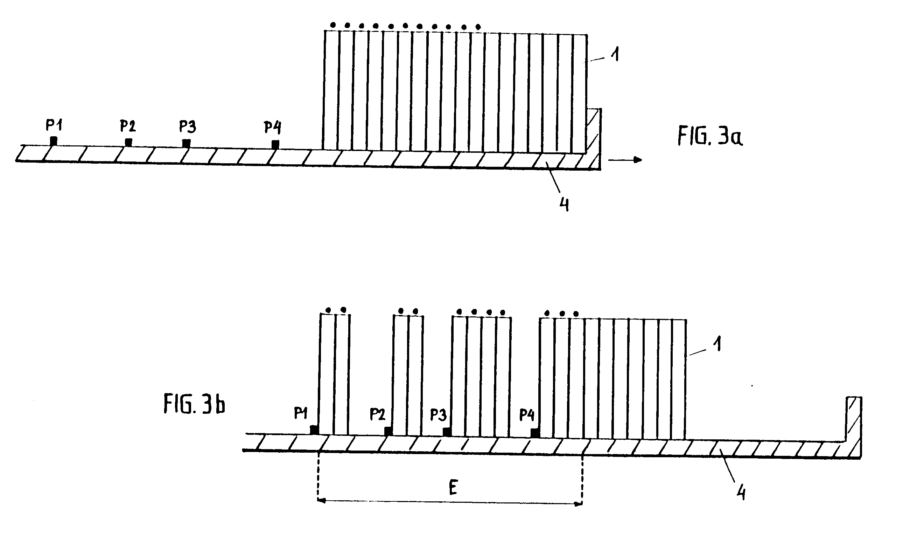

Die Funktionsweise der Vorrichtung soll an einem praxisnahen Beispiel anhand von Fig. 3 verdeutlicht werden, das sich auf eine Anwendung zum Bestücken von Steckverbindern mit Kontaktelementen, d.h. mit Kontaktstiften oder -messern bezieht. Fig. 3a zeigt die Ausgangslage. Die Anzahl der insgesamt zur Verfügung stehenden Zangen 1 betrage 18, welche sich zunächst alle im Einsatzbereich E befinden. Diese Zahl entspricht somit den maximal gleichzeitig bestückbaren Anschlussstiftpositionen. Das Muster für die zu bestückende Kontaktreihe mit 18 Stiftpositionen sehe wie folgt aus: 3 Kontakte - 2 Leerstellen - 4 Kontakte - 2 Leerstellen - 2 Kontakte - 3 Leerstellen - 2 Kontakte. Es sind also insgesamt nur 11 Kontaktelemente einzusetzen und bestimmte dazwischenliegende Positionen freizuhalten. In der Ausgangslage ist die gemäss dem gewünschten Muster mit Positionierstiften P1 ... P4 versehene Platte 4 noch nicht eingeschoben. Durch hier nicht weiter darzustellende Mittel wird die Vorrichtung nun in eine Lage gebracht, in der die ersten 11 Zangen 1 (von links) entsprechend der Anzahl der zu bestückenden 11 Kontaktpositionen auf den die Kontaktelemente anliefernden Träger zugreifen können. Die 11 Zangen 1 entnehmen je ein Kontaktelement und halten es fest. Diese Zangen 1 sind in Fig. 3a mit einem Punkt an ihrem freien Ende gekennzeichnet. Hierauf wird die Positionierplatte 4 in der Vorrichtung nach rechts verschoben. Dadurch werden entsprechend der Anordnung der Positionierstifte P1 ... P4 die Zangen 1 paketweise nach rechts verschoben. Der Positionierstift P4 läuft dabei auf die Positioniermarke der zehnten Zange 1 von rechts auf, wodurch diese mit den neun dahinter liegenden Zangen 1 nach rechts verschoben wird, und zwar bis in eine Stellung, wo die sieben kein Kontaktelement tragenden Zangen 1 ausserhalb des Einsatzbereiches sind. Es bleiben also nur drei Zangen 1 des ersten Paketes im Einsatzbereich, nämlich diejenigen mit den Kontaktelementen. Der Positionierstift P3 läuft während der Verschiebung auf die Positioniermarke der vierzehnten Zange 1 von rechts auf und schiebt diese mit den drei dahinterliegenden Zangen 1 nach rechts. Entsprechendes geschieht mit den Positionierstiften P2 und P1, woraus sich schliesslich die in Fig. 3b dargestellte Anordnung der Zangen 1 ergibt. Diese Anordnung entspricht dem gewünschten Muster der Kontaktanordnung auf dem Steckverbinder.

Alle einen Stift tragenden Zangen 1 befinden sich damit im Einsatzbereich der Vorrichtung. Diese kann nun in eine Lage verbracht werden, in der die Kontaktelemente direkt eingepresst werden. Oder sie kann an eine Bestückungsanlage, z.B. eine Einpressstation, übergeben werden, wo die Kontaktelemente gleichzeitig in einem Arbeitsgang in den Steckverbinder eingesetzt werden.

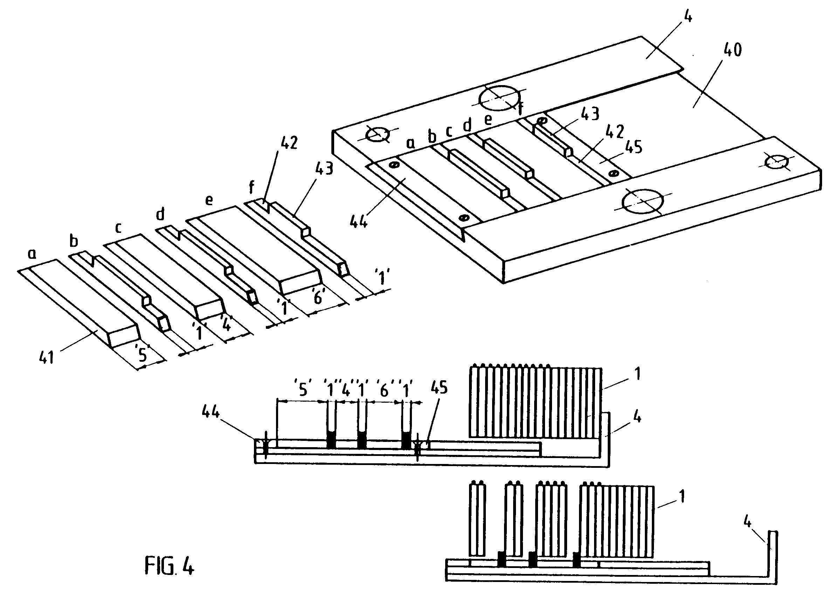

Einen anderen Aufbau der Positioniereinrichtung 4 zeigt Fig. 4. Hier weist die Platte 4 eine nutenartige Vertiefung auf, welche eine Programmierebene 40 bildet, in die nebeneinander wahlweise Abstandselemente 41 und Positionierelemente 42 einsetzbar sind. Diese Elemente sind an ihren beiden Enden leicht angewinkelt und lassen sich so zwischen die entsprechend ausgebildeten Ränder der Programmierebene 40 einschieben. Es sind Abstandelemente 41 verschiedener Breite ('5','4','6') verfügbar. Die Positionierelemente 42 haben die Breite '1' und weisen auf ihrer Oberseite einen Kamm 43 auf. Es sind Positionerelemente 42 mit Kämmen 43 unterschiedlicher Länge verfügbar. Aus einem Satz unterschiedlicher Abstands- bzw. Positionierelemente 41, 42 lässt sich somit die Platte 4 derart programmieren, dass bei deren Verschiebung in Richtung der Objektträger 1 (Fig. 1) die gewünschte Anordnung der Objektträger entsteht. Die in die Programmierebene 40 eingesetzten Abstands- und Positionierelemente 41, 42 werden auf beiden Seiten je mit einer Fixierleiste 44, 45 festgehalten. Die Verschiebung der Objektträger in ihre vorgesehene Lage verläuft prinzipiell gleich wie anhand von Fig. 3 beschrieben. Ein Beispiel für das Erzeugen einer Anordnung mit (von rechts) 3 Besetztstellen - 2 Leerstellen - 4 Besetztstellen - 2 Leerstellen - 2 Besetztstellen - 3 Leerstellen - 2 Besetztstellen ist in Fig. 4 unten gezeigt. Von den in diesem Fall insgesamt 18 zur Verfügung stehenden Objektträgern befinden sich nach der Verschiebung deren 11 innerhalb und die restlichen 7 ausserhalb des Einsatzbereiches E. Zur Verdeutlichung sind in der Figur die verwendeten Elemente 41, 42 mit Buchstaben a bis f gekennzeichnet.

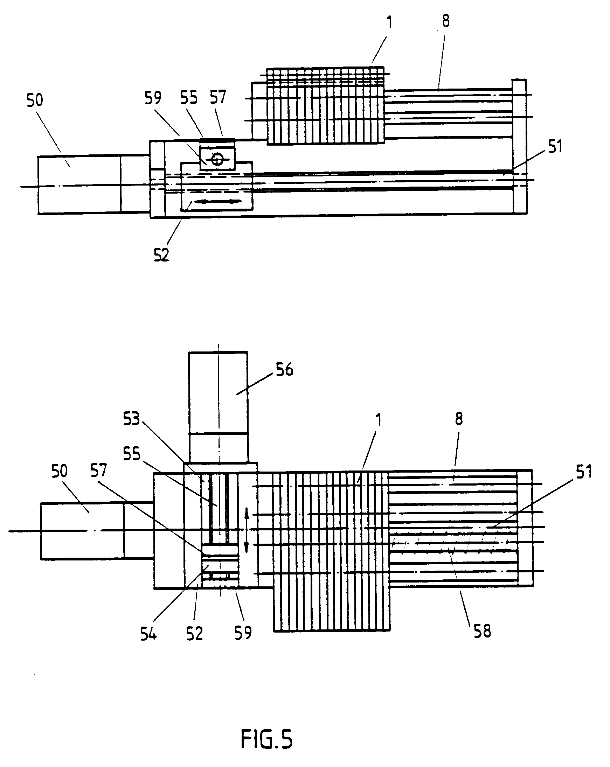

Die Positioniereinrichtung 4 kann auch als Zweiachsensteuerung aufgebaut sei. Die im vorliegenden Zusammenhang wesentlichen Teile einer solchen Steuerung sind in Fig. 5 gezeigt, oben in einer Seiten- und unten in einer Draufsicht. Auf einer parallel zu den Führungssaulen 8 verlaufenden und z. B. von einem Schrittmotor 50 angetriebenen Spindel 51 ist ein Träger 52 vorgesehen. Der Träger 52 weist eine horizontal verlaufende und senkrecht zur Spindel 51 stehende Führungsbahn 53 auf, in der sich ein Schlitten 54 befindet, der uber eine weitere Spindel 55 mit einem weiteren Schrittmotor 56 in der Führungsbahn 53 verschiebbar ist. Die Spindel 55 ist am Ende der Führungsbahn 53 in einem Lagerblock 59 gehalten. Der Schlitten 54 trägt einen senkrecht zu den Objekttragern 1 verlaufenden Kamm 57. Über den Schrittmotor 56 lässt sich somit der Kamm 57 in jede beliebige Position innerhalb der Führungsbahn 53 bringen. Damit ist es möglich, durch entsprechende Ansteuerung der Schrittmotoren 50, 56 die Objektträger 1 wiederum in eine gewünschte Anordnung zu bringen. Die Objektträger 1 werden dabei gegen eine Druckfeder 58 geschoben. Dabei erfolgt die Verschiebung der Objektträger 1 schrittweise, indem nach jedem Verschieben eines Paketes von Objekttragern 1 der Schlitten 54 und damit der Kamm 57 zunächst wieder in die zum Verschieben des nächsten Paketes erforderliche Stellung gebracht wird. Die Ansteuerung der Schrittmotoren 50, 56 kann durch eine frei programmierbare Steuerung erfolgen, was eine besonders einfache Erzeugung verschiedenster Anordnungen der Objektträger 1 ermöglicht. Die Druckfeder 58 sorgt dafür, dass die Objektträger 1 mitgenommen werden, sobald sich der Träger 52 zwecks Rückkehr in die Ausgangslage nach links bewegt.

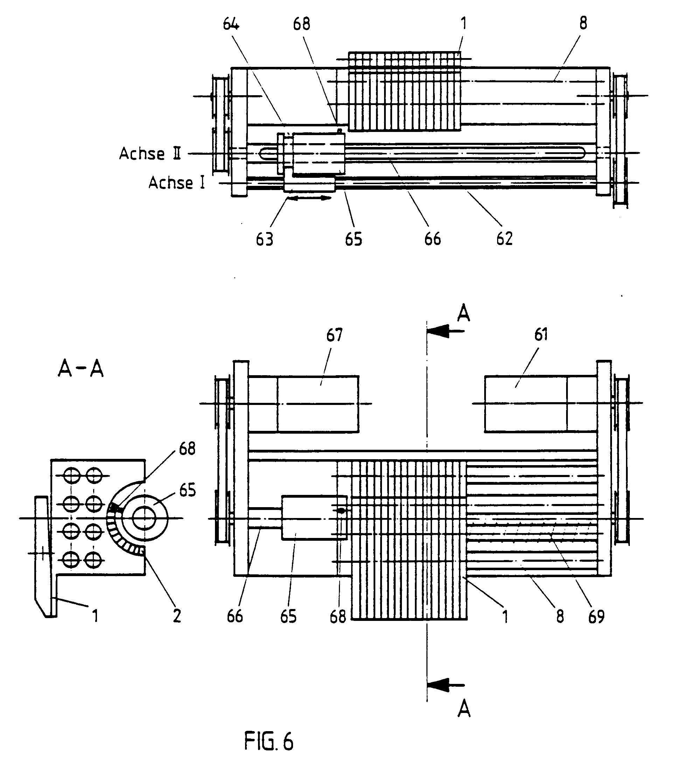

Eine weitere Ausführungsform der Positioniereinrichtung 4 als Zweiachsensteuerung (Achse I, Achse II) zeigt Fig. 6, wiederum oben in einer Seiten- und unten in einer Draufsicht sowie zusätzlich mit einem Schnitt senkrecht zur Verschieberichtung der Objektträger 1. Diese sind an den Führungssäulen 8 geführt. Die Objektträger 1 weisen auf ihrer nach unten gerichteten Seite einen halbkreisförmigen Einschnitt auf, dessen Rand mit den individuellen Positioniermarken 2 versehen ist. Diese Marken 2 sind als auf dem Rand einstückig angebrachte kreisringförmige und verschieden lange Abschnitte ausgebildet. Ein Schrittmotor 61 ist über Antriebselemente mit einer Spindel 62 verbunden, mit welcher ein Schlitten 63 gekoppelt ist. Der Schlitten 63 greift in eine umlaufende Nut 64 eines zylindrischen Positionierelementes 65, welches mit einer Keilwelle 66 radial fest verbunden und axial verschiebbar gekoppelt ist. Die Welle 66 ist über Antriebselemente mit einem weiteren Schrittmotor 67 gekoppelt. An dem den Objektträgern. 1 zugewandten Ende trägt das Positionierelement 65 einen Nocken 68. Die Verschiebung der Objektträger 1 in eine gewünschte Lage zueinander geschieht prinzipiell wiederum schrittweise gleich wie beim vorstehenden Beispiel. Zunächst wird über den Schrittmotor 67 der Nocken 68 durch Drehen des Positionierelementes 65 in die erforderliche Stellung gebracht und anschliessend über den Schrittmotor 61 der Schlitten 63 um den erforderlichen Weg nach rechts bewegt, wobei das betreffende erste Paket von Objektträgern in die gewünschte Lage gelangt. Hierauf wird das Positionierelement 65 wieder nach links in eine Einstellage gebracht und dort wieder gedreht, bis der Nocken 68 die richtige Stellung einnimmt. Anschliessend wird das Positionierelement 65 wieder nach rechts verschoben und dabei das nachste Paket von Objektträgern 1 in die gewünschte Lage gebracht, usw. Auch bei diesem Beispiel kann die Ansteuerung der -Schrittmotoren 61, 67 durch eine frei programmierbare Steuerung erfolgen, um so in einfacher Weise beliebige Anordnungen der Objekttrager 1 zu erzeugen. Eine Druckfeder 69 hat die gleiche Funktion wie die Druckfeder 58 in Fig. 5.

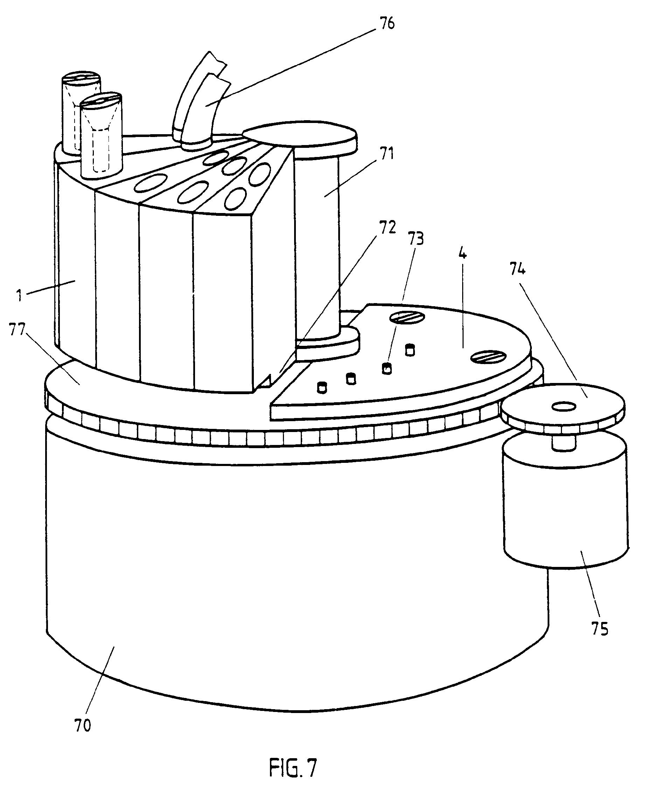

Das Prinzip der erfindungsgemassen Vorrichtung lässt sich auch anwenden, wenn die Verschiebebahn der Objekttrager nicht entlang einer Geraden, sondern bogenformig verläuft. Die wesentlichen Merkmale einer derartigen Vorrichtung zeigt Fig. 7. An einer in einem Grundkörper 70 gehaltenen Trägerachse 71 sind strahlenförmig Objektträger 1 derart drehbar angeordnet, dass sie um die Achse 71 auf einer kreisförmigen Bahn schwenkbar sind. In diesem Beispiel sind die Objektträger 1 mit Spannzangen ausgerüstet, welche pneumatisch über Zuleitungen 76 betätigbar sind. Jeder Objektträger 1 weist auf seiner dem Grundkörper 70 zugewandten Seite wiederum eine als Absatz ausgebildete Positioniermarke 72 mit individueller Länge auf. Zwischen den Objektträgern 1 und dem Grundkörper 70 ist eine auswechselbare scheibenförmige Positionierplatte 4 auf einer Grundplatte 77 angeordnet, die um die Achse 71 drehbar ist. Die Drehung der Grundplatte 77 erfolgt über ein Antriebsrad 74, das mit einem Motor 75 verbunden ist. Auf der Platte 4 lassen sich Positionierstifte 73 einsetzen. Deren Verteilung wird so gewählt, dass bei Drehung der Grundplatte 77 die Objektträger 1 aus der gezeichneten Ausgangslage in die gewünschte Anordnung in einem kreisförmigen Einsatzbereich gelangen. Das Erzeugen einer bestimmten Anordnung der Objektträger 1 untereinander verläuft somit prinzipiell gleich wie bei der Vorrichtung gemäss Fig. 1, weshalb sich weitere Erläuterungen hierzu erübrigen.

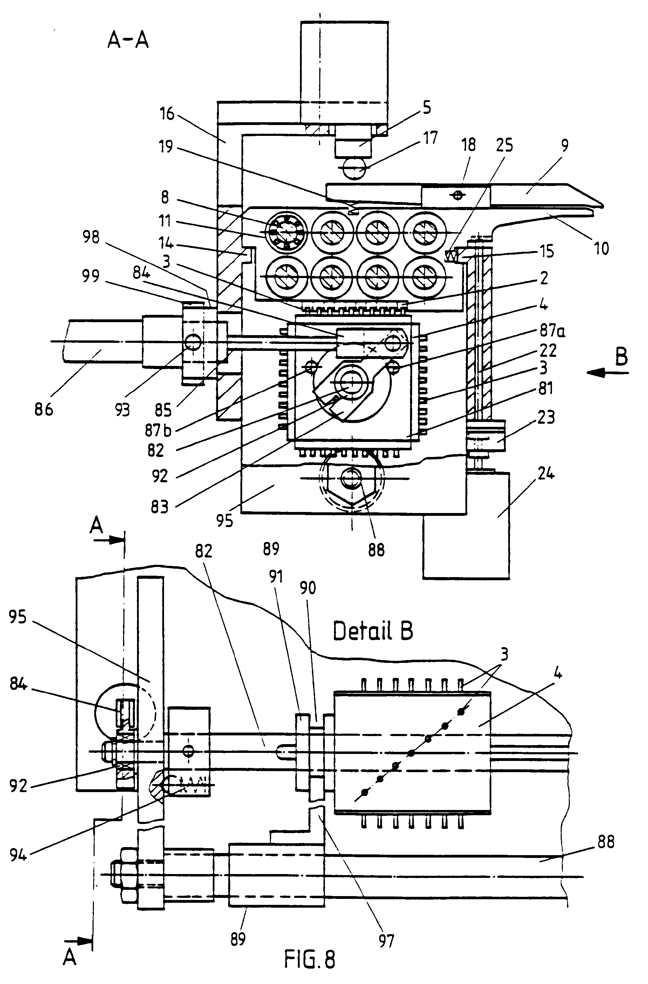

Eine mehr als eine Positioniereinrichtung aufweisende Ausführungsform der erfindungsgemässen Vorrichtung ist in Fig. 8 oben in einer Draufsicht und unten in einem Schnittbild dargestellt. Den Fig. 1 und 2 entsprechende Teile sind auch hier mit gleichen Hinweiszeichen versehen. Dieses Beispiel weist vier auf den Seitenflächen eines prismatischen Trägers 81 angeordnete plattenförmige Positioniereinrichtungen 4 auf, in die wahlweise Positionierstife 3 einsetzbar sind. Der Träger 81 ist auf einer Keilwelle 82 längsverschiebbar, aber nicht drehbar angeordnet, d.h. radial sitzt der Träger 81 auf der Keilwelle 82 fest und dreht beim Drehen der Keilwelle 82 mit. Ein Hebel 83 ist über eine Freilaufkupplung 92 mit der Welle 82 verbunden. Wird der Hebel 83 aus der gezeichneten Lage nach links bewegt, nimmt er die Welle 82 mit; wird er dann wieder nach rechts bewegt, herrscht zwischen dem Hebel 83 und der Welle 82 Freilauf, weshalb diese nicht mitdreht. An seinem freien Ende ist der Hebel 83 über einen Gelenkkörper 84 mit einem Gestänge 85 verbunden, das mit dem Kolben eines z.B. pneumatisch betriebenen Zylinders 86 verbunden ist. Das Ende des Zylinders 86 ist in einem Schwenklager 99 gehalten. Das Schwenklager 99 ist mittels einer Lagerachse 93 gelenkig an einem Lagerbock 98 gelagert, der an dem die Führung 14 enthaltenden Träger 6 befestigt ist. Wird der Zylinder 86 aktiviert, zieht er den Hebel 83 aus der gezeichneten Lage vom Anschlag 87a zum Anschlag 87b, wodurch der Träger 81 um 90 Grad nach links gekippt wird. Dadurch wird die nachstfolgende Platte 4 mit einer anderen Anordnung der Positionierstifte 3 in die den Positioniermarken 2 an den Objekttragern (Zangen 9, 10) gegenuberstehende aktive Lage versetzt. Hierauf wird der Hebel 83 wieder in seine Ausgangslage zum Anschlag 87a gebracht, wobei infolge der Freilaufkupplung 92 der Träger 81 in seiner Lage verbleibt. Die Längsverschiebung des Trägers 81 auf der Keilwelle 82 kann prinzipiell wie bei der Ausführung nach Fig. 6 oder mittels eines kolbenstangenlosen Zylinders 88 erfolgen, auf dem ein Schlitten 89 angeordnet ist. Dieser greift über ein Verbindungsstück 97 in eine umlaufende Nut 90 an einem mit dem Träger 81 verbundenen Kupplungsteil 91. Ein auf der Welle 82 festsitzendes Rastelement 94 sorgt dafür, dass die Welle 82 an einer Stütze 95 arretiert wird, sobald der Träger 81 die gewunschte Position eingenommen hat.

Mit dieser Ausführung können bis zu vier unterschiedlich mit Positionierstiften 3 bestückte Platten 4 hintereinander zur Positionierung der Objektträger eingesetzt werden. Dies ist z.B. beim Bestücken von mehrreihigen Steckverbindern von Vorteil, wenn jede Reihe ein anderes Muster für die Kontaktanordnung aufweist.

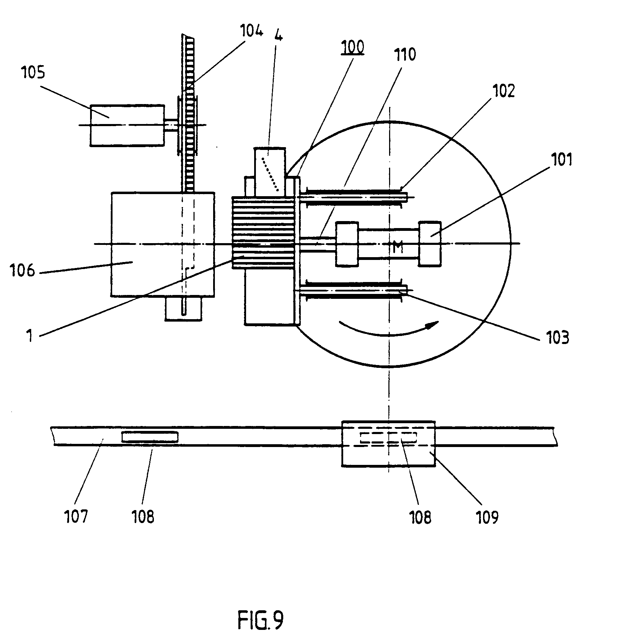

Das Prinzip für die erwähnte Anwendung der erfindungsgemässen Vorrichtung zum Bestücken von Steckverbindern mit Kontaktelementen zeigt Fig. 9. Diese zeigt eine Draufsicht auf eine die Vorrichtung enthaltende Anordnung. Die Vorrichtung 100 ist an einem Träger 101 angebracht, der um eine senkrecht zur Darstellungsebene stehende Achse M drehbar ist. Ausserdem ist die Vorrichtung 100 auf am Träger 101 angebrachten Führungen 102, 103 in Richtung der Längsachse des Trägers 101 verschiebbar. Der Träger 101 ist als Druckzylinder ausgebildet, dessen Kolbenstange 110 mit der Vorrichtung 100 verbunden ist. Ein die Kontaktelemente enthaltender Streifen 104 wird mittels einem bezüglich der Anzahl zuzuführender Kontaktelemente programmierbaren Vorschubgerät 105 in eine Trenneinrichtung 106 vorgeschoben, die die gewünschte Anzahl Kontaktelemente vom Streifen 104 trennt und vereinzelt. Die reihenweise Zuführung der Kontaktelemente kann auch in einer anderen bekannten Art erfolgen. Die Vorrichtung 100 entnimmt mit ihren Objektträgern 1 diese Kontaktelemente aus der Trenneinrichtung 106. Hierauf werden die Objektträger 1 entsprechend dem gewünschten Muster für die Kontaktbestückung wie vorstehend ausführlich beschrieben in eine bestimmte Lage zueinander gebracht. Gleichzeitig wird die Vorrichtung 100 um 90 Grad gegen eine Einpressstation 109 gedreht, welcher die zu bestückenden Steckverbinderkörper 108 auf einem Band 107 zugeführt werden. Jeder Steckverbinderkörper 108 wird in der Einpresstation 109 in die zum Einsetzen der Kontaktelemente richtige Lage gebracht. Hierauf setzt die Vorrichtung 100 die Kontaktelemente lagerichtig in den Steckverbinderkörper 108 ein. Durch gleichzeitigen Einsatz von mehreren, z.B. vier Vorrichtungen 100 mit unterschiedlich programmierten Positioniereinrichtungen 4 lassen sich mit dieser Anordnung in vorteilhafter Weise auch Steckverbinderkörper 108 mit verschiedene Bestückungsmuster aufweisenden Kontaktreihen bestücken. Der Einsatz von mehreren Vorrichtungen 100 ist auch vorteilhaft, wenn mehrreihige Steckverbinder mit gleichem Muster zu bestücken sind, da dann die Taktzeit herabgesetzt werden kann. Die Langsverschiebung des Tragers 101 und dessen Drehung kann mit bekannten pneumatisch betriebenen Mitteln erfolgen. Die Steuerung des Tragers 101, des Vorschubgerates 105, der Trenneinrichtung 106 und des Bandes 107 kann von einer zentralen Steuereinrichtung übernommen werden, welche unter Berücksichtigung vorgegebener Taktzeiten programmierbar ist.

Die Anwendung der erfindungsgemässen Vorrichtung ist keineswegs auf den Fall der Kontaktbestückung von Steckverbindern beschränkt. So lässt sie sich auch in Anlagen zum maschinellen Bestücken von Schaltungsträgern mit verschiedenartigsten elektrischen oder elektronischen Bauelementen verwenden, wobei entsprechend ausgebildete Objektträger vorzusehen sind. Es ist auch denkbar, in einer Vorrichtung unterschiedlich ausgebildete Objektträger vorzusehen, die jeweils bezüglich ihrer Anzahl und Form den zu handhabenden Gegenständen entsprechen.

Ein weiterer Einsatzfall im Bereich der Elektrotechnik betrifft das maschinelle Überführen von Bauelementen von einem ersten Raster in ein unterschiedliches zweites Raster. Diese Aufgabe stellt sich insbesondere beim Umrüsten der Kontaktelemente eines Prüfadapters von einem ersten in ein zweites Raster zur Anpassung des Prüfadapters an verschiedenste Prüflinge. Dabei ist unwesentlich, ob es sich bei den beiden Rastern um regelmässige oder unregelmässige Raster handelt, da sich die Vorrichtung durch entsprechende Programmierung der Verschiebung der Objektträger prinzipiell an jedes Raster anpassen lässt.

Eine weitere vorteilhafte Anwendungsmöglichkeit der Vorrichtung bietet sich beim Aufbringen von SMD-Bauelementen auf elektrische Schaltungsträger, indem der auf dem Schaltungsträger zunächst an den für die Bauelemente vorgesehenen Stellen aufzubringende Klebstoff durch einen oder mehrere entsprechend ausgebildete Objektträger zugeführt wird. Die mit einem Klebstofftank verbundenen und beispielsweise mit einer Düse ausgerüsteten Objektträger dienen in diesem Fall nicht eigentlich zum Festhalten von Objekten und Erzeugen einer bestimmten Anordnung der Objekte untereinander, sondern vielmehr zum Aufnehmen und gezielten Verteilen eines Fabrikationswerkstoffes.

Diese Beispiele deuten die Vielfalt der denkbaren Anwendungsmöglichkeiten der erfindungsgemässen Vorrichtung an, wobei ohne weiteres auch eine Vielzahl von Einsatzfällen ausserhalb der Elektrotechnik in Frage kommt. Sie ist prinzipiell überall dort einsetzbar, wo an sich beliebige Gegenstände gefasst, in eine bestimmte Anordnung zueinander gebracht und so weitergegeben werden müssen.

## Patentansprüche

1. Vorrichtung zum Handhaben von Objekten, mit Trägern zum Aufnehmen der Objekte, wobei mehrere Objektträger (1) vorgesehen sind, die derart beweglich auf einer vorgegebenen Bahn angeordnet sind, dass sie auf dieser Bahn frei gegeneinander verschiebbar sind und mindestens eine programmierbare Positioniereinrichtung (4) vorgesehen ist, die die Objektträger (1) in eine Lage mit frei wählbaren Abständen zueinander bringt.

2. Vorrichtung nach Anspruch 1, **dadurch gekennzeichnet**, dass die Objektträger (1) auf einer linearen Bahn verschiebbar sind.

3. Vorrichtung nach Anspruch 1, **dadurch gekennzeichnet**, dass die Objektträger (1) auf einer gebogenen Bahn verschiebbar sind.

4. Vorrichtung nach einem der vorangehenden Ansprüche, **dadurch gekennzeichnet**, dass als Objektträger (1) Zangen oder vakum - oder magnetbetriebene Greifer vorgesehen sind.

5. Vorrichtung nach einem der vorangehenden Ansprüche, **dadurch gekennzeichnet**, dass als Positioniereinrichtung eine in Richtung der Objektträger (1) verschiebbare Platte (4) mit wahlweise einsetzbaren Positionierelementen (3; 41, 42) vorgesehen ist, welche Elemente (3; 41, 42) beim Verschieben der Platte (4) auf entsprechende Positioniermarken (2) an den Objektträgern (1) auflaufen und dabei eine entsprechende Anzahl Objektträger (1) innerhalb eines Einsatzbereiches in eine bestimmte Position zueinander bringen.

6. Vorrichtung nach Anspruch 5, **dadurch gekennzeichnet**, dass die Positioniereinrichtung mehrere Platten (4) aufweist, von denen wahlweise jeweils eine in eine Lage schwenkbar ist, in der sie anschliessend in Richtung der Objektträger (1) verschiebbar ist.

7. Vorrichtung nach Anspruch 6, **dadurch gekennzeichnet**, dass die Platten (4) auf den Seitenflächen eines Trägers (81) angeordnet sind, der radial fest und axial verschiebbar mit einer Welle (82) verbunden ist, und dass die Welle (82) über eine Freilaufkupplung (92) mit einem Antrieb (85, 86) verbunden ist, bei dessen Aktivierung die Welle (82) um einen wählbaren Winkel gedreht wird.

8. Vorrichtung nach einem der Ansprüche 1, 2 oder 4, **dadurch gekennzeichnet**, dass als Positioniereinrichtung eine Zweiachsensteuerung vorgesehen ist, in der ein entlang der in Verschieberichtung verlaufenden ersten Achse (51) verschiebbarer Träger (52) und ein entlang der senkrecht zur Verschieberichtung stehenden zweiten Achse (55) verschiebbarer Schlitten (54) mit einem Positionierelement (57) vorhanden sind, welches beim Verschieben des Tragers (52) auf entsprechende Positioniermarken (2) an den Objektträgern (1) aufläuft.

9. Vorrichtung nach einem der Ansprüche 1, 2 oder 4, **dadurch gekennzeichnet**, dass als Positioniereinrichtung eine Zweiachsensteuerung vorgesehen ist, bei der ein entlang der in Verschieberichtung verlaufenden ersten Achse (62) verschiebbarer Schlitten (63) vorhanden ist, der mit einem auf der parallel zur ersten Achse (62) verlaufenden zweiten Achse (66) drehbar gelagerten Positionierelement (65) gekoppelt ist, das einen Nocken (68) aufweist, der beim Verschieben des Schlittens (63) und Drehen des Positionierelementes (65) auf entsprechende Positioniermarken (2) an der Objekttragern (1) aufläuft.

10. Vorrichtung nach einem der Ansprüche 1, 3 oder 4, **dadurch gekennzeichnet**, dass ein Träger (71) vorgesehen ist, an dem die Objektträger (1) strahlenförmig und derart drehbar angeordnet sind, dass sie auf einer kreisförmigen Bahn gegeneinander verschiebbar sind, und dass eine ebenfalls um den Träger (71) drehbare Positioniereinrichtung (4) mit wahlweise einsetzbaren Positionierelementen (73) vorgesehen ist, die bei Drehung der Positioniereinrichtung (4) auf entsprechende Positioniermarken (2) an den Objektträgern (1) auflaufen.

11. Vorrichtung nach Anspruch 5, 6 oder 10, **dadurch gekennzeichnet**, dass als Positionierelemente Stifte (3; 73) vorgesehen sind, welche in Bohrungen der Platte (4) steckbar sind.

12. Vorrichtung nach Anspruch 5, **dadurch gekennzeichnet**, dass die Positioniereinrichtung (4) eine Programmierebene (40) aufweist, in die wahlweise Abstandselemente (41) und Positionierelemente (42) nebeneinander einsetzbar sind.

13. Vorrichtung nach einem der Ansprüche 5 bis 12, **dadurch gekennzeichnet**, dass Arretierungen (22) vorgesehen sind, um die Objekttrager (1) nach dem Verschieben in ihrer Lage zu fixieren.

14. Anwendung der Vorrichtung nach Anspruch 1, in einer Anlage zum maschinellen Einsetzen von Kontaktelementen in einen entsprechende Offnungen aufweisenden Träger (108), wobei die Kontaktelemente reihenweise, z.B. auf einem Streifen (104) zugeführt, diesem entnommen, dann in eine gewunschte Anordnung zueinander gebracht und schliesslich in dieser Anordnung in den Träger (108) eingesetzt werden.

15. Anwendung der Vorrichtung nach Anspruch 1, um in einem ersten Raster angeordnete Objekte in eine Anordnung mit unterschiedlichem zweiten Raster überzuführen.

16. Anwendung der Vorrichtung nach Anspruch 1, in einer Anlage zum Bestücken eines Bauelementeträgers mit mechanischen oder elektrischen Bauelementen.

## Claims

1. Device for handling objects, with holders for receiving the objects, wherein a plurality of object holders (1) are provided which are movably arranged on a predetermined path in such a manner as to be freely displaceable relative to one another on said path and at least one programmable positioning device (4) is provided which brings the object holders (1) into a position with freely selectable clearances from one another.

2. Device according to claim 1, characterised in that the object holders (1) are displaceable along a linear path.

3. Device according to claim 1, characterised in that the object holders (1) are displaceable along a curved path.

4. Device according to any of the preceding claims, characterised in that tongs or grippers operated by vacuum or magnets are provided as the object holders (1).

5. Device according to any of the preceding claims, characterised by providing as the positioning device a plate (4) displaceable in the direction of the object holders (1) and having positioning elements (3; 41, 42) which can be used as required, said elements (3; 41, 42) moving to corresponding position markers (2) on the object holders (1) as the plate (4) is displaced and at the same time bringing a corresponding number of object holders (1) into a given position within an operative range.

6. Device according to claim 5, characterised in that the positioning device incorporates a plurality of plates (4), any given one of which may be swivelled as required into a position in which it can subsequently be displaced in the direction of the object holders (1).

7. Device acording to claim 6, characterised in that the plates (4) are arranged on the lateral faces of a holder (81) which is connected in a radially fixed and axially displaceable manner to a shaft (82), and in that the shaft (82) is connected via an overriding clutch (92) to a drive unit (85, 86) which when activated causes the shaft (82) to rotate by a selectable angle.

8. Device according to any one of claims 1, 2 or 4, characterised by providing as the positioning device a two-axis control unit comprising a holder (52), which can be displaced along the first axis (51) running in the direction of displacement, and a slide (54) with a positioning element (57), which can be displaced along the second axis (55) perpendicular to the direction of displacement, said positioning element (57) moving to corresponding position markers (2) on the object holders (1) as the holder (52) is displaced.

9. Device according to any one of claims 1, 2 or 4, characterised by providing as the positioning device a two-axis control unit comprising a slide (63) which can be displaced along the first axis (62) running in the direction of displacement and which is coupled to a positioning element (65) rotatably mounted on the second axis (66) parallel to the first axis (62), said positioning element (65) incorporating a cam (68) which moves to corresponding position markers (2) on the objects holders (1) as the slide (63) is displaced and the positioning element (65) rotated.

10. Device according to any one of claims 1, 3 or 4, characterised by providing a holder (71) on which the object holders (1) are arranged radially and rotatably in such a manner that they can be displaced relative to one another on a circular path, and by providing a positioning device (4) which is likewise rotatable about the holder (71) and has positioning elements (73) which can be used as required and which move to corresponding position markers (2) on the object holders (1) as the positioning device (4) is rotated.

11. Device according to claim 5, 6 or 10, characterised in that the positioning elements provided are pins (3; 73) which can be pushed into holes drilled in the plate (4).

12. Device according to claim 5, characterised in that the positioning device (4) has a programming plane (40) into which spacing elements (41) and positioning elements (42) can be inserted alongside one another as required.

13. Device according to any one of Claims 5 to 12, characterised in that catches (22) are provided to secure the object holders (1) in position after being displaced.

14. Use of the device according to claim 1 in an installation for the automated insertion of contacts into a holder (108) incorporating corresponding openings, the contacts being supplied in series on, for example, a strip (104), removed therefrom, then put into a desired arrangement with one another and finally inserted in this arrangement into the holder (108).

15. Use of the device according to claim 1 for transferring objects disposed in a first grid into an arrangement with a different second grid.

16. Use of the device according to claim 1 in an installation for fitting a component holder with mechanical or electrical components.

## Revendications

1. Dispositif pour manipuler des objets, comportant des supports servant à recevoir les objets, et dans lequel il est prévu plusieurs porte-objets (1), qui sont disposés de manière à être déplaçables sur une trajectoire prédéterminée de telle sorte qu'ils peuvent être librement déplacés les uns par rapport aux autres sur cette trajectoire, et qu'il est prévu au moins un dispositif de positionnement programmable (4), qui amène les porte-objets (1) dans des positions dans lesquelles ils sont situés à des distances pouvant être librement choisies.

2. Dispositif suivant la revendication 1, caractérisé par le fait que les porte-objets (1) sont déplaçables sur une trajectoire linéaire.

3. Dispositif suivant la revendication 1, caractérisé par le fait que les porte-objets (1) sont déplaçables sur une trajectoire courbe.

4. Dispositif suivant l'une des revendications précédentes, caractérisé par le fait qu'il est prévu, comme porte-objets (1), des pinces ou des dispositifs de préhension activés par une dépression ou par des aimants.

5. Dispositif suivant l'une des revendications précédentes, caractérisé par le fait qu'il est prévu, comme dispositif de positionnement, une plaque (4) déplaçable en direction des porte-objets (1) et comportant des éléments de positionnement (3;41,42) pouvant être utilisés au choix, ces éléments (3;41,42) passant sur des repères correspondants de positionnement (2) situés sur les porte-objets (1), lors du déplacement de la plaque (4) et amenant un nombre correspondant de porte-objets (1) dans des positions réciproques déterminées, dans une zone d'utilisation.

6. Dispositif suivant la revendication 5, caractérisé par le fait que le dispositif de positionnement possède plusieurs plaques (4), dont au choix l'une peut être amenée par pivotement dans une position dans laquelle elle est ensuite déplaçable en direction des porte-objets (1).

7. Dispositif suivant la revendication 6, caractérisé par le fait que les plaques (4) sont disposées sur les surfaces latérales d'un support (81), qui est raccordé de manière à être fixe radialement et déplaçable axialement, à un arbre (82), et que l'arbre (82) est raccordé, par l'intermédiaire d'un accouplement à roue libre (92) à un dispositif d'entraînement (85,86), lors de l'activation duquel l'arbre (82) tourne sur un angle pouvant être sélectionné.

8. Dispositif suivant l'une des revendications 1, 2 ou 4, caractérisé par le fait qu'il est prévu, comme dispositif de positionnement, une unité de commande à deux axes, dans laquelle un support (52) déplaçable le long du premier axe (51) qui s'étend dans la direction de translation, et un chariot (54), qui peut se déplacer le long du second axe (55) perpendiculaire à la direction de translation et comporte un élément de positionnement (57) qui, lors du déplacement du support (52), passe sur des marques correspondantes de positionnement (2) situées sur les porte-objets (1).

9. Dispositif suivant l'une des revendications 1, 2 ou 4, caractérisé par le fait qu'il est prévu comme dispositif de positionnement une unité de commande à deux axes, dans laquelle il est prévu un chariot (63) déplaçable le long du premier axe (62) qui s'étend dans la direction de translation, et qui est accouplé à un élément de positionnement (65) monté rotatif sur le second axe, qui est parallèle au premier axe (62), et qui possède une came (68) qui, lors de la translation du chariot (63) et de la rotation de l'élément de positionnement (65), passe sur des marques correspondantes de positionnement (2) situées sur les porte-objets (1).

10. Dispositif suivant l'une des revendications 1, 3 ou 4, caractérisé par le fait qu'il est prévu un support (71), sur lequel les porte-objets (1) sont disposés selon des rayons et peuvent tourner de sorte qu'ils peuvent être déplacés les uns par rapport aux autres sur une trajectoire circulaire, et qu'il est prévu un dispositif de positionnement (4), qui peut également tourner autour du support (71) et comporte des éléments de positionnement (73) pouvant être utilisés au choix et qui, lors de la rotation du dispositif de positionnement (4), passent sur des repères correspondants de positionnement (2) situés sur les porte-objets (1).

11. Dispositif suivant la revendication 5, 6 ou 10, caractérisé par le fait qu'il est prévu, comme éléments de positionnement, des tiges (3;73), qui sont enfichables dans des passages de la plaque (4).

12. Dispositif suivant la revendication 5, caractérisé par le fait que le dispositif de positionnement (4) possède un plan de programmation (40), dans lequel on peut insérer au choix des éléments-entretoises (41) et des éléments de positionnement (42) côte-à-côte.

13. Dispositif suivant l'une des revendications 5 à 12, caractérisé par le fait qu'il est prévu des dispositifs de blocage (42) destinés à fixer en position les porte-objets (1) après le déplacement.

14. Utilisation du dispositif suivant la revendication 1, dans une installation servant à insérer mécaniquement des éléments de contact dans un support (108) comportant des ouvertures correspondantes, les éléments de contact étant amenés selon une rangée, par exemple sur une bande (104), étant prélevés de cette dernière, puis amenés dans une disposition réciproque désirée et étant enfin insérée, avec cette disposition, dans le support (38).

15. Utilisation du dispositif suivant la revendication 1 pour placer des objets disposés selon un premier réseau, dans une disposition correspondant à un second réseau différent.

16. Application du dispositif suivant la revendication 1, dans une installation pour équiper un porte-composants avec des composants mécaniques ou électriques.
